(19) **Europäisches Patentamt**
**European Patent Office**
**Office européen des brevets**

(11) **EP 2 896 904 A1**

(12) **EUROPEAN PATENT APPLICATION**
published in accordance with Art. 153(4) EPC

(43) Date of publication:
**22.07.2015 Bulletin 2015/30**

(51) Int Cl.:
***F24F 11/04*** (2006.01)       ***F24F 7/06*** (2006.01)
***H05K 7/20*** (2006.01)

(21) Application number: **13837810.4**

(22) Date of filing: **10.09.2013**

(86) International application number:
**PCT/JP2013/074389**

(87) International publication number:
**WO 2014/042151 (20.03.2014 Gazette 2014/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **11.09.2012 JP 2012199793**

(71) Applicant: **Hitachi, Ltd.**
**Tokyo 100-8280 (JP)**

(72) Inventors:
• **KASHIRAJIMA Yasuhiro**
**Tokyo 100-8280 (JP)**
• **SHIMOKAWA Ryoji**
**Tokyo 100-8280 (JP)**

(74) Representative: **Beetz & Partner mbB**
**Patentanwälte**
**Steinsdorfstraße 10**
**80538 München (DE)**

(54) **AIR-CONDITIONING CONTROL SYSTEM**

(57)     To provide an air-conditioning control system in which air-conditioning can be performed in an efficient manner. This invention is provided with: an air supply temperature adjustment means for adjusting the air supply temperature to a predetermined value; an air supply fan (18); an air supply fan inverter (45) for controlling the rotation speed of the air supply fan (18); an air discharge fan (19); an air discharge fan inverter (46) for controlling the rotation speed of the air discharge fan (19); an operation information management means for managing the operation information for a plurality of servers (22); and a control means for calculating the air supply amount so as to cancel out the heat generated by the servers (22) and calculating the frequency of the air supply fan inverter (45) and the air discharge fan inverter (46).

FIG. 1

## Description

### TECHNICAL FIELD

The present invention relates to an air-conditioning control system configured to perform air-conditioning of a space to be air-conditioned where multiple electronic devices are provided.

### BACKGROUND ART

Throughput required in information processing has been increasing in recent years along with improvements in information processing technologies and developments in the Internet environment, and data processing centers for processing a large amount of various types of information are drawing attention as a promising business. For example, numerous electronic devices are intensively installed in a server room of a data processing center, and are continuously operated all day and all night.

Meanwhile, rack mounting is becoming the mainstream of a method of installing electronic devices in a server room. The rack mounting is a method designed to stack racks (housings) in a cabinet, where an electronic device is segmented into functional units and housed in each rack. A large number of such cabinets are arrayed on the floor of the server room.

In addition, a gross amount of heat generation from electronic devices has been steadily increasing along with rapid improvements in processing capacities of the electronic devices. Meanwhile, the electronic devices continuously exposed to a high temperature are likely to cause trouble such as system breakdown. It is therefore necessary to set an environmental temperature around the electronic devices equal to or below a predetermined value.

Accordingly, the fact is that air-conditioning power required for cooling inside the server room has been significantly increasing, and it is an urgent need to reduce the air-conditioning power not only from the viewpoint of cost reduction in light of corporate management but also from the viewpoint of global environmental protection.

For example, Patent Document 1 describes an air-conditioning system provided with one or more outdoor units, and multiple indoor units installed in the same target space. The air-conditioning system includes a first deciding unit that decides the number of operating indoor units on the basis of outdoor supply heat quantity which is quantity of heat supplied from the outdoor units to the target space, and of second specification information which is information relating to specifications of each indoor unit.

### PRIOR ART DOCUMENT

### PATENT DOCUMENT

Patent Document 1: Japanese Patent Application Publication No. 2006-220345

### SUMMARY OF THE INVENTION

### PROBLEMS TO BE SOLVED BY THE INVENTION

The technique described in Patent Document 1 is designed to reduce the number of the operating indoor units only when a predetermined condition to stop operation is satisfied, and to control on and off of each of the indoor units. Accordingly, when a change (an amount of reduction) in air-conditioning load is small, this technique may fail to perform delicate air-conditioning control corresponding to such a change and be incapable of performing energy-saving operation appropriately.

Meanwhile, when a machine room (a space to be air-conditioned) where numerous electronic devices are installed is air-conditioned, an air current inside the machine room may become unstable and heat may become stagnant if part of the multiple indoor units are stopped.

As described above, the technique described in Patent Document 1 may not be capable of performing air-conditioning efficiently.

In view of the above, it is an object of the present invention to provide an air-conditioning control system capable of performing air-conditioning efficiently.

### MEANS FOR SOLVING THE PROBLEMS

To solve the problems, the present invention is characterized in that an air-conditioning control system includes control means for calculating an air supply amount by using operation information inputted from operation information management means so as to cancel out heat generated by multiple electronic devices installed in a space to be air-conditioned, and calculating frequencies of an air supply fan inverter and an air discharge fan inverter on the basis of the air supply amount.

Further details will be described in the chapter MODES FOR CARRYING OUT THE INVENTION.

### EFFECTS OF THE INVENTION

The present invention can provide an air-conditioning control system which performs air-conditioning efficiently.

### BRIEF DESCRIPTION OF THE DRAWINGS

Fig. 1 is a configuration diagram (a schematic cross-sectional view) of an air-conditioning control system according to a first embodiment of the present invention.

Fig. 2 is a schematic plan view showing a layout of multiple server racks provided in a server room and showing relations between cold aisles and hot aisles.

Fig. 3 is a configuration diagram of a control system provided to the air-conditioning control system.

Fig. 4A is a graph showing a relation between power consumption by a server and an amount of air required while Fig. 4B is a graph showing a relation between an air supply amount of cold air to be supplied to a server room and a frequency of an air supply fan inverter.

Figs. 5A and 5B are graphs concerning an air-conditioning control system according to a second embodiment of the present invention, in which Fig. 5A is a graph showing a relation between a frequency of a cooling fan and an amount of air required while Fig. 5B is a graph showing a relation between an air supply amount of cold air to be supplied to a server room and a frequency of an air supply fan inverter.

Fig. 6 is an explanatory diagram (a schematic cross-sectional view) of servers installed in a server room in an air-conditioning control system according to a third embodiment of the present invention.

Fig. 7 is a graph showing a relation between power consumption by a server and an amount of air required in an air-conditioning control system according to a fourth embodiment of the present invention.

MODES FOR CARRYING OUT THE INVENTION

Modes for carrying out the invention (hereinafter referred to as embodiments) will be described in detail with reference to the drawings as appropriate.

In the following, a case of performing air-conditioning of a server room, in which multiple servers are installed, by using cold of external air (i.e., applying an air-conditioning method using external air) will be described as an example.

«First Embodiment»

<Configuration of Air-conditioning Control System>

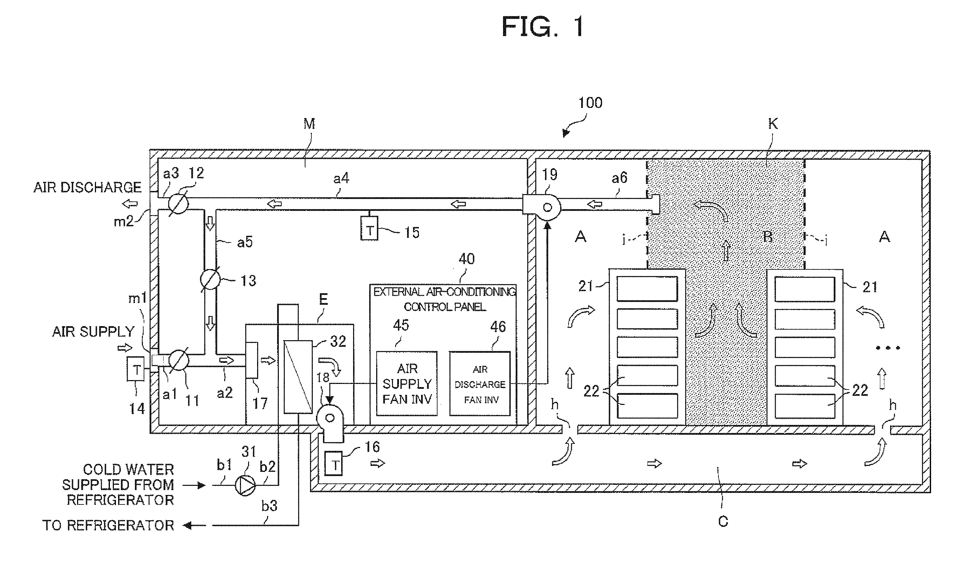

Fig. 1 is a configuration diagram (a schematic cross-sectional view) of an air-conditioning control system of this embodiment.

A left side of the sheet of Fig. 1 illustrates a machine room M where an external air conditioning control panel 40 and the like are installed. A right side of the sheet of Fig. 1 illustrates a server room K which is a space to be air-conditioned. Meanwhile, an outlet of an air supply fan 18, which is installed in an external air conditioner E, and the server room K are connected to each other through an underfloor chamber C and connection holes h.

In the following descriptions, an unprescribed server rack will be indicated as a server rack 21 while an unprescribed server will be indicated as a server 22.

An air-conditioning control system 100 is a system for conditioning air in the server room K (the space to be air-conditioned), in which multiple servers 22 (electronic devices) are installed, by using external air being a cold source. Electronic devices such as the servers 22 are required to perform accurate operations. For this reason, a temperature of each built-in CPU (central processing unit) needs to be kept from reaching a predetermined heatproof temperature. In the meantime, if cold air at an extremely low temperature (such as 5°C) is supplied to the server room K, the cold air may cause dew condensation. Such a situation has to be avoided.

Accordingly, in order to maintain an operating environment for the servers 22 in a proper condition, this embodiment performs control in such a way that a temperature of air supply from the air supply fan 18 becomes equal to a predetermined target temperature (such as 20°C).

The air-conditioning control system 100 shown in Fig. 1 includes an external air supply-discharge system configured to supply and discharge the external air to and from the server room K, and a cold water circulation system configured to circulate cold water in summer and the like, and a control system configured to control operations of the air-conditioning control system 100.

(External Air Supply-discharge System)

The external air supply-discharge system includes dampers 11, 12, and 13, a filter 17, the air supply fan 18, an air discharge fan 19, and pipes a1 to a6 to connect these components.

The damper 11 is connected to an air supply port m1 through the pipe a1 and is configured to adjust an amount of flow of the external air that flows in through the pipe a1. Meanwhile, the damper 11 is connected to the filter 17, which is installed inside the external air conditioner E, through the pipe a2.

The damper 12 is connected to an air discharge port m2 through the pipe a3 and is configured to adjust an amount of flow of air (warm air) discharged through the pipe a3. Meanwhile, the damper 12 is connected to an outlet of the air discharge fan 19 through the pipe a4.

Note that the aforementioned air supply port m1 and the air discharge port m2 are connected to the outside of the system (the external air).

The damper 13 is provided to the pipe a5 that connects the pipe a2 to the pipe a4, and is configured to adjust an amount of flow of the warm air that returns to the pipe a2 on the air supply side. In other words, the external air (the cold air) in the amount of flow corresponding to the degree of opening of the damper 11 and the air (the warm air) in the amount of flow corresponding to the degrees of openings of the dampers 12 and 13 flow into the pipe a2 on the air supply side, and the air thus mixed is directed to the filter 17.

Incidentally, the external air conditioning control panel 40 controls the degrees of openings of the dampers 11, 12, and 13 on the basis of a detection value by a temperature sensor 14 provided to the air supply port m1 and a detection value by a temperature sensor 15 provided to the pipe a4, and in such a way that an air supply temperature from the air supply fan 18 becomes equal to a predetermined value (such as 20°C). Here, the air supply temperature from the air supply fan 18 is detected by a temperature sensor 16 shown in Fig. 1 and is inputted to the external air conditioning control panel 40.

The filter 17 is installed in the external air conditioner E and is connected to the pipe a2. The filter 17 has a function to remove dust in the air that flows in through the pipe a2.

The air supply fan 18 is installed in the external air conditioner E and is located downstream of a heat exchanger 32 to be described later. The air supply fan 18 has a function to supply the air that is adjusted to the predetermined temperature to the server room K. Here, the outlet of the air supply fan 18 is connected to cold aisles A (low-temperature regions) in the server room K through the underfloor chamber C as well as the numerous connection holes h provided in the floor of the server room K.

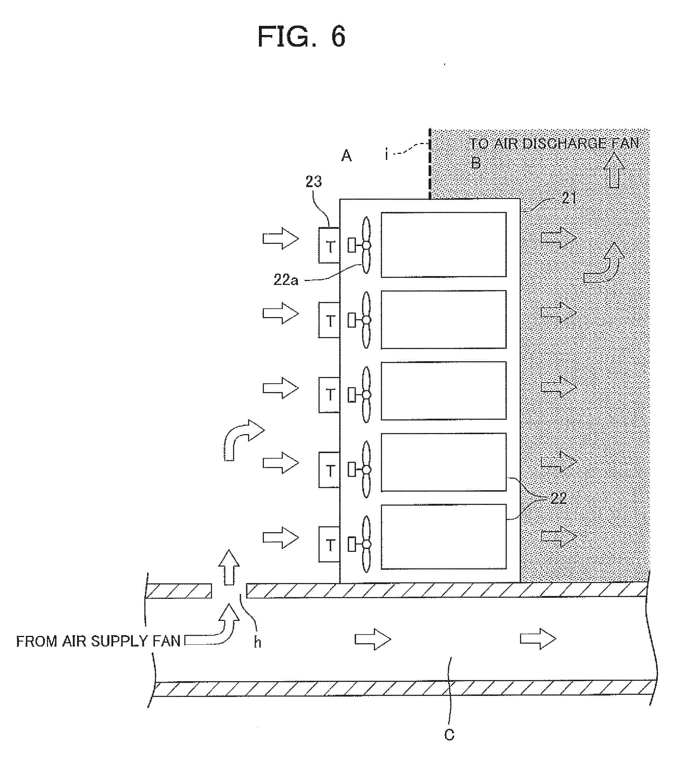

An inlet of the air discharge fan 19 is connected to a hot aisle B (a high-temperature region) in the server room K through the pipe a6 and an outlet thereof is connected to the air discharge port m2 through the pipe a4, the damper 12, and the pipe a3. The air discharge fan 19 has a function to discharge the air at a high temperature (such as 35°C), which is blown out of a cooling fan 22a (see Fig. 6) of each server 22, from the server room K.

Here, a layout of servers 22 in the server room K will be described. As shown in Fig. 1, multiple server racks 21 for housing the servers 22 are disposed on the floor of the server room K. Meanwhile, multiple (five in Fig. 1) servers 22 are stacked on each server rack 21.

Although illustration is omitted in Fig. 1, each server 22 incorporates the cooling fan 22a (see Fig. 6), which takes in the cold air in the cold aisle A from a back face (an intake side) and blows out the warm air from a front face (a blowout side) toward the hot aisle B. During this process, the cold air taken in by the cooling fan 22a absorbs heat generated by the server 22 and turns into the warm air. On the other hand, the server 22 releases the heat by the heat exchange with the cold air and is kept equal to or below a predetermined heatproof temperature.

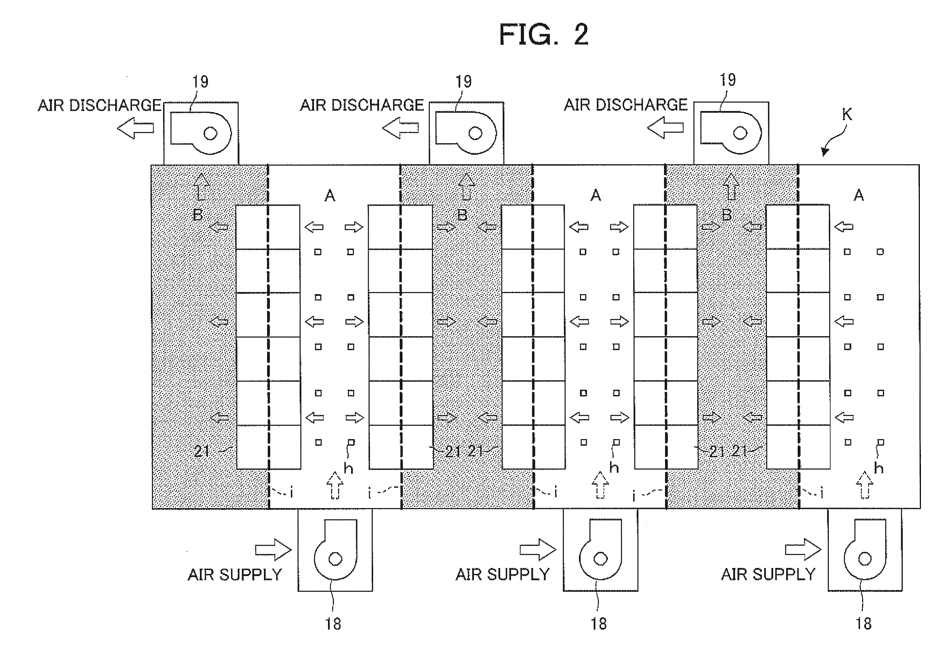

Fig. 2 is a schematic plan view showing the layout of the multiple server racks provided in the server room and showing relations between the cold aisles and the hot aisles. Note that Fig. 2 omits illustration of a region upstream of the air supply fans 18 and a region downstream of the air discharge fans 19. Moreover, although Fig. 2 schematically illustrates the connection holes h provided in the floor, numerous connection holes h are provided in reality.

As shown in Fig. 2, numerous server racks 21 are arranged in multiple rows (five rows in Fig. 2) in the server room K and disposed in such a way that the servers 22 provided on two adjacent rows face one another. For example, the servers 22 are disposed in such a way that a back face (the intake side) of each server 22 on the first row from the left and a back face (the intake side) of each server 22 on the second row therefrom face each other. Here, the inlets of the cooling fans 22a (see Fig. 6) face the cold aisle A (the low-temperature region).

Meanwhile, for example, the servers 22 are disposed in such a way that a front face (the blowout side) of each server 22 on the second row from the left and a front face (the blowout side) of each server 22 on the third row therefrom face each other. Here, the outlets of the cooling fans 22a face the hot aisle B (the high-temperature region).

As shown in Fig. 1 and Fig. 2, spaces between the ceiling of the server room K and upper faces of the server racks 21 (or the floor where the server racks 21 are not present) are partitioned by using vinyl curtains i. By partitioning the server room K into the cold aisles A and the hot aisles B as described above, the warm air blown out of the cooling fans 22a (see Fig. 6) is kept from flowing into the cold aisles A, and cooling efficiency is thus improved.

Meanwhile, as shown in Fig. 2, the air supply fans 18 are provided corresponding to the respective cold aisles A and the air discharge fans 19 are provided corresponding to the respective hot aisles B.

As described previously, the outlet of each air supply fan 18 faces the corresponding cold aisle A through the underfloor chamber C (see Fig. 1) and the connection holes h, while the inlet of each air discharge fan 19 faces the server room K. In the meantime, the server room K is substantially hermetically sealed with the exception of the provision of the connection holes h and inlets of the air discharge fans 19.

Meanwhile, the air supply temperature when the air is supplied from the air supply fans 18 to the server room K is adjusted to a predetermined value (such as 20°C) by air supply temperature adjustment means. Here, the "air supply temperature adjustment means" includes the dampers 11, 12, and 13 (see Fig. 1), the temperature sensors 14, 15, and 16 (see Fig. 1), and the external air conditioning control panel 40 (see Fig. 1).

(Cold Water Circulation System)

Back to Fig. 1, the description will be continued. The heat exchanger 32 is built into the external air conditioner E and is interposed between the filter 17 and the air supply fan 18. A cold water pump 31 is connected to one end of the heat exchanger 32 through a pipe b2, and is driven in accordance with an instruction from a control device (not shown) for the cold water circulation system. Although illustration is omitted in Fig. 1, a cold storage tank which stores a predetermined amount of the cold water, a refrigerator configured to supply the cold to the water stored in this cold storage tank, and the like are provided through pipes b1 and b3.

If the external air temperature is relatively low as in spring or fall (so-called an intermediate season) or in winter, the air-conditioning control system 100 can supply the cold of the external air to the servers 22 by performing the air-conditioning using the external air.

On the other hand, when the external air temperature is relatively high as in summer, it is difficult to supply the cold to the servers 22 by performing the air-conditioning using the external air. Accordingly, when the external air temperature (or enthalpy per unit weight of the external air) is equal to or above a predetermined value, the air-conditioning control system 100 supplies the cold to the servers 22 by feeding the cold water to the heat exchanger 32.

In this case, it is preferable to control a blowout temperature from the air supply fan 18 at a predetermined value (such as 20°C) by using the control device (not shown) for the cold water circulation system.

(Control System)

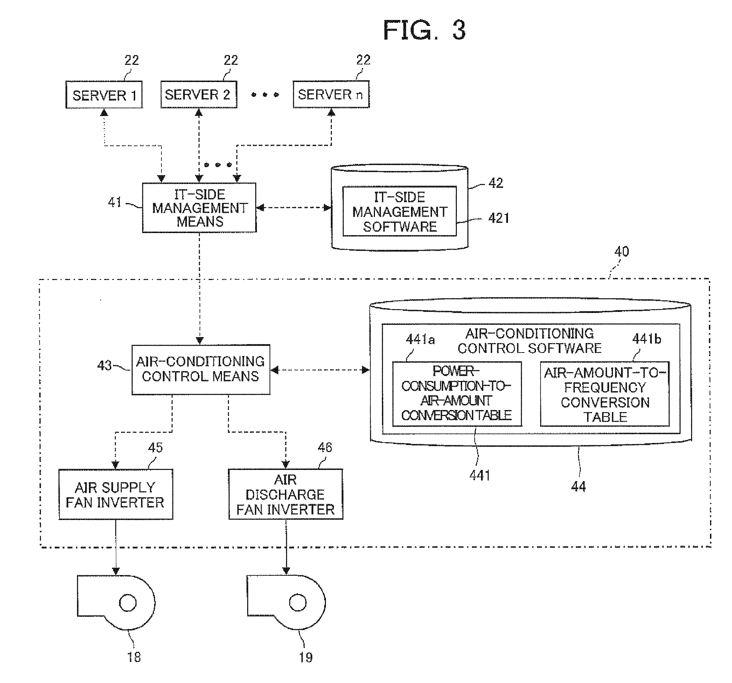

Fig. 3 is a configuration diagram of the control system provided to the air-conditioning control system. The control system includes IT-side management means 41, first storage means 42, air-conditioning control means 43, second storage means 44, an air supply fan inverter 45, and an air discharge fan inverter 46.

The IT-side management means 41 (operation information management means) includes a CPU, and manages operation information on the respective servers 22 by reading IT-side management software 421 stored in the first storage means 42. Here, the operation information includes, for example, power consumption, a CPU utilization rate, and a frequency of the cooling fan 22a (see Fig. 6) in terms of each of the servers 22.

The IT-side management means 41 can communicate with the servers 22 (servers 1, 2, ..., n shown in Fig. 3) installed in the server room K. The IT-side management means 41 consecutively acquires the above-described operation information from each of the servers 22.

In this embodiment, the IT-side management means 41 is set to acquire the operation information on each of the servers 22 including the power consumption thereof at a predetermined time interval, and to output the acquired operation information to the air-conditioning control means 43.

The first storage means 42 includes a RAM (random access memory), a ROM (read only memory), an HDD (hard disk drive), and the like, and stores the IT-side management software 421 for realizing the above-described functions of the IT-side management means 41.

The air-conditioning control means 43 (the control means) includes a CPU, and executes control processing for performing the air-conditioning using the external air by reading air-conditioning control software 441 stored in the second storage means 44. Meanwhile, the control processing for performing the air-conditioning using the external air will be described later.

The second storage means 44 includes a RAM, a ROM, an HDD, and the like, and stores the air-conditioning control software 441 for performing the air-conditioning using the external air. Meanwhile, a power-consumption-to-air-amount conversion table 441a and an air-amount-to-frequency conversion table 441b included in the air-conditioning control software 441 will be described later.

Incidentally, the air-conditioning control means 43, the second storage means 44, the air supply fan inverter 45, and the air discharge fan inverter 46 are provided to the above-described external air conditioning control panel 40 (see Fig. 1).

The air supply fan inverter 45 is driven at a predetermined frequency in accordance with an instruction signal (such as a PWM (pulse width modulation) signal) inputted from the air-conditioning control means 43. Here, the air supply fan inverter 45 is connected to a motor (not shown) installed in the air supply fan 18, and rotates the motor at a rotation speed corresponding to the aforementioned frequency.

The air discharge fan inverter 46 has the same configuration as that of the air supply fan inverter 45 described above. Here, the air discharge fan inverter 46 is connected to a motor (not shown) installed in the air discharge fan 19.

<Air-conditioning Control Processing>

Next, air-conditioning control processing applying the air-conditioning using the external air will be described with reference to Fig. 3.

In this embodiment, the air-conditioning control means 43 calculates an amount of air to be supplied by the air supply fan 18 (an air supply amount) by using the power consumption by (the operation information on) each of the servers 22 inputted from the IT-side management means 41, and drives the air supply fan 18 and the air discharge fan 19 accordingly.

As described above, the IT-side management means 41 is communicably connected to the servers 22. The IT-side management means 41 acquires the power consumption by each of the servers 22 at the predetermined time interval and outputs the acquired power consumption to the air-conditioning control means 43. Here, the above-described information on the power consumption is acquired from all the servers 22 operating in the server room K.

Next, the air-conditioning control means 43 refers to the power-consumption-to-air-amount conversion table 441a stored in the second storage means 44, and determines an amount of air required which corresponds to the power consumption acquired from the server 22. It is to be noted that the power-consumption-to-air-amount conversion table 441a is a table that defines a relation between the power consumption by the server 22 and the above-described amount of air required.

Meanwhile, the above-described "amount of air required" means an amount of air per unit time period to be supplied to the server 22 (a specific server from which the power consumption is to be acquired) in order to avoid a rise in temperature of the relevant server 22.

In the meantime, in order to suppress the rise in temperature of the server 22 and to maintain the server 22 within a predetermined temperature range, it is necessary to supply the sufficient cold for cancelling out the heat (warmth) generated by the server 22. Meanwhile, the air supply temperature (the temperature detected by the temperature sensor 16) of the air supply fan 18 is controlled at a predetermined target temperature (such as 20°C).

Accordingly, the amount of the cold to be supplied to the server room K (the space to be air-conditioned) per unit time period is determined solely by the amount of the cold air supplied from the air supply fan 18.

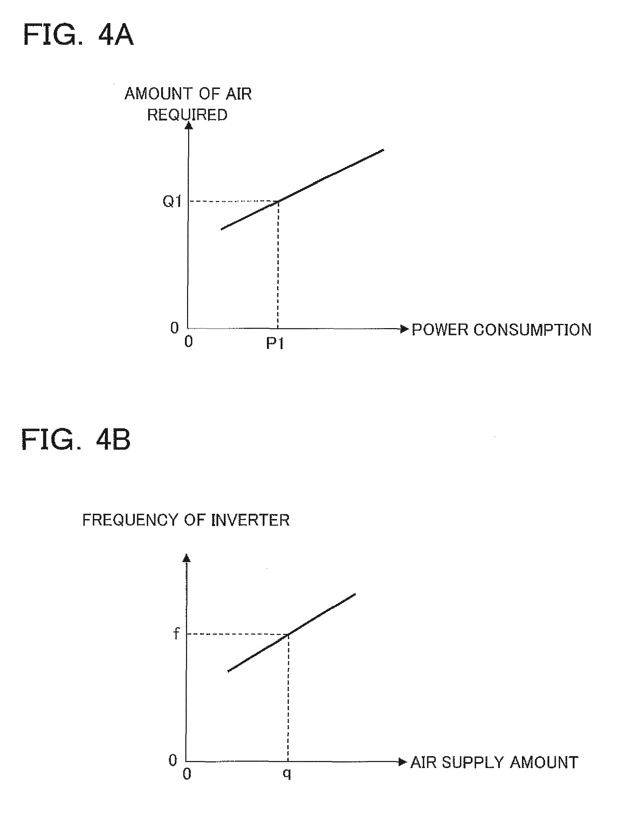

Fig. 4A is a graph showing a relation between the power consumption by the server and the amount of air required. As shown in Fig. 4A, a correlation formula (a graph) for calculating the amount of air required by the server 22 is preset on the basis of the power consumption by the server 22. Meanwhile, since there is a positive correlation between the power consumption by the server 22 and an amount of heat generated by the server 22 per unit time period, the amount of air required is set larger as the power consumption by the server 22 becomes larger.

Here, the relation between the power consumption by the server 22 and the amount of air required may also be set as a table having a given data structure (that is, as the power-consumption-to-air-amount conversion table 441a: see Fig. 3).

Incidentally, the minimum amount of the cold air required for cancelling out the heat generated by the server 22 is not determined only by the power consumption by the server 22, but may also vary depending on other factors (such as an intake temperature at the cooling fan 22a built into the server 22: see Fig. 6). In this embodiment, the amount of air required is provided with a given allowance so that the necessary cold can be supplied to the server 22 even when the above-mentioned other factors vary.

Fig. 4B is a graph showing a relation between the air supply amount of the cold air to be supplied to the server room and the frequency of the air supply fan inverter.

The air-conditioning control means 43 determines the amounts of air required by the respective servers 22 while referring to the power-consumption-to-air-amount conversion table 441a, and sums up the values. For example, when there are the servers 1, 2, ..., n shown in Fig. 3 as the servers 22 and the amounts of air required by the respective servers 22 are Q1, Q2, ..., Qn, an air supply amount q of the air supply fan 18 is expressed by the following (Formula 1):

$$q = Q1 + Q2 + \ldots + Qn \quad (Formula\ 1).$$

As described above, the air-conditioning control means 43 calculates the air supply amount q of the air supply fan 18 by summing up the amounts of air required by the respective servers 22. Here, the air supply amount q is an amount of the cold air supplied in order to cancel out the heat generated in the server room K (the space to be air-conditioned). A frequency f (see Fig. 4B) of the air supply fan inverter 45 is determined corresponding to the air supply amount.

As shown in Fig. 4B, a correlation formula between the air supply amount and the frequency is preset such that the frequency of the air supply fan inverter 45 (that is, the rotation speed of the air supply fan 18) becomes higher as the air supply amount is larger. Here, the relation between the air supply amount and the frequency may also be set as a table having a given data structure (that is, as the air-amount-to-frequency conversion table 441b: see Fig. 3).

The air-conditioning control means 43 determines the frequency corresponding to the air supply amount by using the air-amount-to-frequency conversion table 441b, and outputs an instruction signal (such as a PWM signal: pulse width modulation), which corresponds to the frequency, to the air supply fan inverter 45. Then, the motor (not shown) installed in the air supply fan 18 is driven at the rotation speed corresponding to the frequency.

In the meantime, since the server room K does not have inlets and outlets for the air with the exception of the connection holes h (see Fig. 1) and the inlet of the air discharge fan 19, the air (the warm air) in the same amount as the amount of the cold air supplied from the air supply fan 18 has to be discharged by using the air discharge fan 19.

Accordingly, the air-conditioning control means 43 finds an air discharge amount from the server room K by using the same method as that used for calculating the air supply amount, and drives the air discharge fan inverter 46 by determining the frequency corresponding to the air discharge amount. Thus, the motor (not shown) installed in the air discharge fan 19 is driven at the rotation speed corresponding to the frequency.

Here, the air supply amount (the amount of the air flowing into the server room K) and the air discharge amount (the amount of the air flowing out of the server room K) become substantially equal to each other, whereas the rotation speed of the air supply fan 18 and the rotation speed of the air discharge fan 19 are not always equal to each other. In other words, the rotation speeds may be different from each other because the air-amount-to-frequency conversion table 441b is set on the basis of the types and numbers of the fans, and the like.

<Effects>

The air-conditioning control system 100 of this embodiment brings about the following effects. Specifically, when the external air temperature is relatively low as in an intermediate season (spring or fall) or in winter, the air-conditioning control system 100 performs the air-conditioning using the cold of the external air.

Since the external air is used as the cold source as described above, the power consumption required for supplying the cold becomes substantially equal to zero. Thus, it is possible to significantly reduce the power consumption required for the air-conditioning control.

In the meantime, when the external air temperature is relatively high as in summer, the cold can be supplied to the servers 22 by driving the refrigerator (not shown) and the cold water pump 31 (see Fig. 1).

Meanwhile, in this embodiment, the amount of flow of the warm air returning from the pipe a4 to the pipe a2 is adjusted by the degrees of openings of the dampers 11, 12, and 13 (see Fig. 1), thereby controlling the air supply temperature of the air supply fan 18 at the predetermined target temperature (in other words, the air supply temperature is set almost constant). Accordingly, a total amount of the cold supplied to the servers 22 is determined solely by the amount of the cold air supplied from the air supply fan 18, or in other words, solely by the rotation speed of the air supply fan 18.

For example, when an amount of the heat (warmth) generated in the server room K is increased in accordance with the operation of the servers 22, the air-conditioning control means 43 increases the rotation speeds of the air supply fan 18 (and the air discharge fan 19) without changing the air supply temperature. In this way, this embodiment is capable of significantly simplifying the processing when the air-conditioning control is performed.

Moreover, in this embodiment, the amount of air required by the servers 22 is calculated by using the information on the power consumption by the respective servers 22, and the air supply amount to be supplied to the server room K is further calculated. As described previously, the power consumption by each server 22 directly affects the amount of heat generated by the server 22. Accordingly, it is possible to appropriately calculate the amount of the cold air required for the air-conditioning by reflecting the power consumption by the respective servers 22 in the amount of air from the air supply fan 18.

Meanwhile, when the air-conditioning is performed by using the external air, most of electric power required for the air-conditioning control is consumed by the air supply fan 18 and the air discharge fan 19. The conventional air-conditioning using the external air performs the control in such a way that a predetermined amount of the cold air is constantly supplied irrespective of a change in power consumption by the servers 22.

In contrast, by controlling the rotation speeds of the air supply fan 18 and the air discharge fan 19 so as to cancel out the heat generated by the servers 22, this embodiment can significantly reduce the power consumption by the air supply fan 18 and the air discharge fan 19 as compared to the conventional example. Accordingly, it is possible to substantially reduce the power consumption required for the air-conditioning control while maintaining safety and reliability of the servers.

Moreover, in this embodiment, the air-conditioning control means 43 determines the air supply amount and the air discharge amount on the basis of the power consumption by the servers 22. Accordingly, as compared to the case of controlling the number of the indoor units as described above in Patent Document 1, this embodiment can perform delicate control of the amount of the cold air to be supplied to the server room K (in other words, the total amount of the cold to be supplied to the servers 22) on the basis of operational states of the servers 22.

In addition, most of the servers 22 are preset to output the power consumption while they are in operation. Even if such setting is not established, the power consumption can easily be acquired by installing an electric power meter(not shown). As described above, since this embodiment uses the power consumption by the servers 22 for the air-conditioning control, the embodiment is applicable to all kinds of servers 22 (electronic devices).

«Second Embodiment»

A second embodiment is different from the first embodiment in that a cooling-fan-frequency-to-air-amount conversion table (not shown) is provided instead of the power-consumption-to-air-amount conversion table 441a described in the first embodiment, and other features of this embodiment are the same as those of the first embodiment. Accordingly, the different features will be hereinbelow explained while the descriptions of the features overlapping the first embodiment will be omitted.

As described previously, each of the servers 22 housed in the server rack 21 incorporates the cooling fan 22a (an electronic device fan: see Fig. 6)

Here, control means (not shown) of each server 22 determines a rotation speed of the cooling fan 22a on the basis of the utilization rate of the CPU, for example. In other words, the control of the cooling fan 22a is accomplished within the server 22 and no external control devices (such as the external air conditioning control panel 40: see Fig. 1) are involved therein.

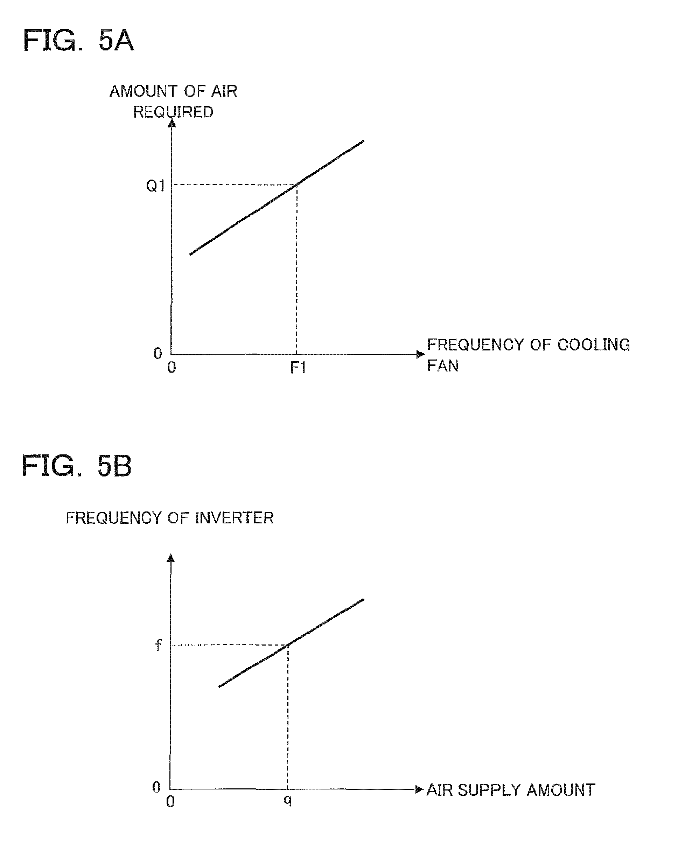

Fig. 5A is a graph showing a relation between a frequency of the cooling fan and an amount of air required. As shown in Fig. 5A, the amount of cold air (the amount of air required) to be supplied to the server 22 becomes larger as the frequency of the cooling fan 22a is higher. Here, the amount of air required shown in Fig. 5A corresponds to an amount of intake air by the cooling fan 22a.

The control means (not shown) of the server 22 determines the rotation speed of the cooling fan 22a in such a way that the CPU or the like is kept from reaching a heatproof temperature (in other words, so as to cancel out the heat generated by the server 22). Accordingly, the heat generated by the server 22 is reflected directly and accurately in the amount of intake air by the cooling fan 22a (that is, the amount of air required).

Here, the relation between the frequency of the cooling fan 22a and the amount of air required may also be set as a table having a given data structure (that is, as the cooling-fan-frequency-to-air-amount conversion table: not shown). The cooling-fan-frequency-to-air-amount conversion table is a table that defines a relation between the frequency of the cooling fan 22a installed in each server 22 and the amount of air (the amount of air required) to be supplied to the server 22, which is stored in the second storage means 44 (see Fig. 3) in advance.

Fig. 5B is a graph showing a relation between the air supply amount of the cold air to be supplied to the server room and the frequency of the air supply fan inverter. Note that the graph shown in Fig. 5B is the same as the graph of Fig. 4B described in the first embodiment, and the description thereof will be omitted.

The air-conditioning control means 43 (see Fig. 3) determines the amounts of air required by the respective servers 22 while referring to the above-mentioned cooling-fan-frequency-to-air-amount conversion table (not shown), and sums up the values. The sum value corresponds to the air supply amount required for cancelling out the heat generated in the server room K (the space to be air-conditioned).

Then, the air-conditioning control means 43 determines the frequency of the air supply fan inverter 45 on the basis of the calculated air supply amount, and drives the air supply fan 18 accordingly. Note that the frequency of the air discharge fan 19 is calculated in accordance with the same method as above.

<Effects>

According to the air-conditioning control system 100 of this embodiment, the amount of air required by each server 22 is calculated on the basis of the frequency of the cooling fan 22a thereof. As described previously, the rotation speed of the cooling fan 22a is controlled in such a way that the CPU mounted on the server 22 is kept from reaching a predetermined heatproof temperature (that is, so as to cancel out the heat generated by the CPU). Accordingly, the frequency of the cooling fan 22a corresponds to the minimum amount of the cold required for cancelling out the heat generated by the server 22 on a one-to-one basis.

As described in the first embodiment, the amount of heat generated by the server 22 is not determined only by the power consumption by the server 22, but may also vary depending on other factors (such as the intake temperature at the cooling fan 22a). For example, when the intake temperature at the cooling fan 22a becomes higher, the minimum amount of the cold air required for cooling the server 22 is increased in accordance therewith. In the power-consumption-to-air-amount conversion table 441a described in the first embodiment, the amount of air required is provided with the given allowance so that the necessary cold can be supplied to the server 22 even when the above-mentioned other factors vary.

In contrast, according to the air-conditioning control system 100 of this embodiment, the amount of heat generated by each server 22 is directly reflected in the amount of air required. Therefore, the minimum amount of the cold air required for cancelling out the heat generated by the server 22 can be accurately calculated by using the cooling-fan-frequency-to-air-amount conversion table (not shown).

Thus, it is possible to reduce the rotation speeds of the air supply fan 18 and the air discharge fan 19 to the requisite minimum, and thereby to minimize the power consumption used for the air-conditioning control.

«Third Embodiment»

As compared to the first embodiment, a third embodiment is different in that each server 22 includes an intake air temperature sensor 23 (see Fig. 6) configured to detect an intake air temperature of the server 22, and an intake air temperature setting table (not shown) is added to the air-conditioning control software 441 (see Fig. 3). However, other features of this embodiment are the same as those of the first embodiment. Accordingly, the different features will be hereinbelow explained while the descriptions of the features overlapping the first embodiment will be omitted.

As described previously, the temperature of the cold air supplied from the air supply fan 18 is controlled at the predetermined target temperature (such as 20°C) by the air-conditioning control means 43. However, the temperature of the cold air may rise if a failure occurs in an air-conditioning facility or any of the vinyl curtains i (see Fig. 1) is opened temporarily during maintenance work.

In this embodiment, the air-conditioning control means 43 increases the rotation speeds of the air supply fan 18 (and the air discharge fan 19) when such an anomaly is detected, thereby increasing the air supply amount of the air supply fan 18.

Fig. 6 is an explanatory diagram (a schematic cross-sectional view) of the servers installed in the server room in the air-conditioning control system. As shown in Fig. 6, each server 22 is provided with the intake air temperature sensor 23 (intake air temperature detection means) configured to detect the temperature of the cold air flowing into the server 22. The intake air temperature sensor 23 detects the temperature of the air flowing into the server 22, and outputs the detected temperature to the air-conditioning control means 43 (see Fig. 3) at a predetermined time interval.

The air-conditioning control means 43 determines whether or not the intake air temperatures inputted from the multiple intake air temperature sensors 23 include one that exceeds a predetermined value (such as 25°C). Then, if there is a temperature that exceeds the predetermined value, the air-conditioning control means 43 refers to the intake air temperature setting table (not shown) and increases the frequency of the air supply fan inverter 45 stepwise. Thereafter, the air-conditioning control means 43 raises the frequency of the air supply fan inverter 45 in such a way that the detection values of all the intake air temperature sensors 23 become equal to or below the predetermined value.

Here, when the amount of the cold air flowing into the server room K through the connection holes h shown in Fig. 6 increases, it is necessary to increase an amount of flow of the warm air to be discharged from the server room K in accordance therewith. Therefore, when the air-conditioning control means 43 raises the frequency of the air supply fan inverter 45 as described above, the air-conditioning control means 43 also raises the frequency of the air discharge fan inverter 46 in accordance therewith.

<Effects>

According to the air-conditioning control system 100 of this embodiment, the intake air temperatures at the cooling fans 22a installed in the respective servers 22 are detected, and if the detection values include the one that exceeds the predetermined value, the air-conditioning control means 43 raises the frequencies of the air supply fan inverter 45 (and the air discharge fan inverter 46).

Therefore, when the intake air temperature at one of the servers 22 is increased due to a failure of an air-conditioning facility, maintenance work, and the like, a large amount of flow of the cold air can be supplied by using the air supply fan 18 and a large amount of the warm air can be discharged by using the air discharge fan 19.

By forcibly increasing the amount of flow of the cold air supply as described above, it is possible to suppress a rise in intake air temperature of each of the servers 22 and to maintain the temperatures of the servers 22 equal to or below the predetermined value.

«Fourth Embodiment»

As compared to the first embodiment, a fourth embodiment is different in that each server 22 includes the intake air temperature sensor 23 configured to detect the intake air temperature, and multiple power-consumption-to-air-amount conversion tables (not shown) are provided to correspond to different intake air temperatures. However, other features of this embodiment are the same as those of the first embodiment. Accordingly, the different features will be hereinbelow explained while the descriptions of the features overlapping the first embodiment will be omitted.

As shown in Fig. 6, each server 22 is provided with the intake air temperature sensor 23 (the intake air temperature detection means) configured to detect the temperature of the cold air flowing into the server 22. The intake air temperature sensor 23 detects the intake air temperature at the server 22, and outputs the detected temperature to the air-conditioning control means 43 (see Fig. 3) at a predetermined time interval.

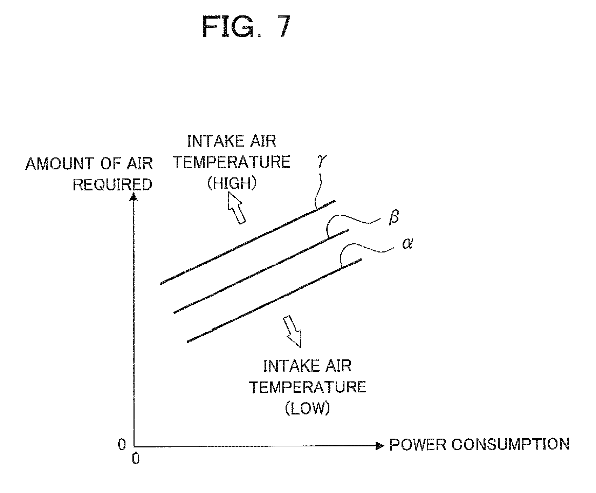

Fig. 7 is a graph showing a relation between the power consumption by the server and the amount of air required. As described previously, the temperature of the cold air supplied from the air supply fan 18 is controlled at the predetermined target temperature (such as 20°C) by the air-conditioning control means 43. Nevertheless, the intake air temperature to be detected by the intake air temperature sensor 23 may fluctuate even if an anomaly does not occur in the air-conditioning control system 100 as mentioned in the third embodiment.

For example, while the multiple servers 22 are staked in each server rack 21, the servers 22 are not necessarily housed in all of housing regions provided in the server rack 21. If there are one or more locations among the housing regions in which the servers 22 are not housed, the warm air blown out of the cooling fans 22a to the hot aisle B may flow into the cold aisle A through the vacant housing regions. In this case, the warm air flowing into the cold aisle A raises the intake air temperatures of the servers 22.

As described above, the intake air temperatures of the servers 22 may change depending on the state of the housing regions provided in the server rack 21. Here, the intake air temperature of the servers 22 may change due to other factors as well.

Accordingly, in this embodiment, the multiple power-consumption-to-air-amount conversion tables (not shown), each of which shows a correlation between the power consumption by the server 22 and the amount of air required and corresponds to a preset temperature range, are stored in the second storage means 44.

For example, as shown in Fig. 7, when the intake air temperature is a low temperature (below 18°C), the air-conditioning control means 43 uses the power-consumption-to-air-amount conversion table that corresponds to a graph $\alpha$ when deriving the amount of air supply from the power consumption by the server 22. Meanwhile, when the intake air temperature is a medium temperature (equal to or above 18°C but below 23°C), the air-conditioning control means 43 uses the power-consumption-to-air-amount conversion table that corresponds to a graph $\beta$. In the meantime, when the intake air temperature is a high temperature (equal to or above 23°C), the air-conditioning control means 43 uses the power-consumption-to-air-amount conversion table that corresponds to a graph γ.

As described above, the air-conditioning control means 43 selects the power-consumption-to-air-amount conversion table (or a correlation formula) that corresponds to the intake air temperature at the cooling fan 22a inputted from the intake air temperature sensor 23.

Note that the tables (or the correlation formulae) are provided on the basis of the types of the servers 22. For example, if five types of the servers 22 are installed in the server room K and each type of the servers 22 uses different power-consumption-to-air-amount conversion tables (not shown) depending on the low, medium, and high intake temperatures as described above, then fifteen (=3×5) power-consumption-to-air-amount conversion tables in total are stored in the second storage means 44 (see Fig. 3).

The air-conditioning control means 43 selects the power-consumption-to-air-amount conversion table (not shown) corresponding to the intake air temperature inputted from each intake air temperature sensor 23, and calculates the amount of air required by the server 22 corresponding to the intake air temperature sensor 23. Moreover, the air-conditioning control means 43 sums up the amounts of air required by all the servers 22 and thus calculates the amount of flow of the cold air (that is, the air supply amount) to be supplied to the server room K. Furthermore, the air-conditioning control means 43 finds the frequencies corresponding to the amount of air supply by referring to the air-amount-to-frequency conversion table 441b (see Fig. 3), and drives the air supply fan 18 and the air discharge fan 19 accordingly. Note that the processing subsequent to the calculation of the amount of air required is the same as that in the first embodiment.

<Effects>

According to the air-conditioning control system 100 of this embodiment, the air-conditioning control means 43 selects the power-consumption-to-air-amount table (not shown) corresponding to the intake air temperature of each server 22. In other words, if the intake air temperature of one of the servers 22 changes depending on the state of housing in the server rack 21 and the like, the air-conditioning control means 43 selects an appropriate power-consumption-to-air-amount conversion table corresponding to the change.

Thus, it is possible to calculate the amount of the cold air required for cancelling out the heat generated by the servers 22 can be calculated more accurately than the first embodiment (in other words, in such a way as to bring the amount of the cold air close to the minimum requisite).

As a consequence, the electric power required for the air-conditioning control can further be reduced as compared to the first embodiment.

Meanwhile, when the frequency of the cooling fan 22a is inputted to the air-conditioning control means 43 as described in the second embodiment, the amount of heat generated by the server 22 is directly reflected in the air supply amount and the air discharge amount. However, there are also servers that are not designed to output the frequencies of the cooling fans 22a therein.

This embodiment is also applicable to such servers not designed to output the frequencies of the cooling fans 22a, because most of the servers are designed to output the power consumption, or if not, the power consumption can easily be acquired by installing an electric power meter.

«Modified Examples»

Although the air-conditioning control system 100 according to the present invention has been described above with reference to certain embodiments, the embodiments of the present invention are not limited to the above descriptions and various modifications are possible.

For example, the above embodiments have described the case where the cold air is supplied to the server room K through the underfloor chamber C and the connection holes h shown in Fig. 1. However, the present invention is not limited to the foregoing. For instance, an air-conditioning unit configured to send the cold air into the cold aisle A and to suck the warm air out of the hot aisle B may be suspended from the ceiling.

Moreover, the above embodiments have described the case where the space to be air-conditioned is the server room K. However, the present invention is not limited to the foregoing. Specifically, the above-described methods are also applicable to a case of air-conditioning a space to be air-conditioned in which electronic devices other than the servers are installed.

Furthermore, the above-described embodiments can be combined as appropriate. For instance, the second embodiment may be combined with the third embodiment. In this case, the air-conditioning control means 43 uses the cooling-fan-frequency-to-air-amount conversion table (not shown) and the air-amount-to-frequency conversion table 441b as the air-conditioning control software 441. Then, if the intake air temperatures to be inputted from the multiple intake air temperature sensors 23 include one that exceeds the predetermined value, the air-conditioning control means 43 increases the frequencies of the air supply fan inverter 45 (and the air discharge fan inverter 46) stepwise.

Likewise, the third embodiment may be combined with the fourth embodiment.

EXPLANATION OF REFERENCE NUMERALS

| 100 | air-conditioning control system |
| K | server room (space to be air-conditioned) |
| 11, 12, 13 | damper (air supply temperature adjustment means) |
| 14, 15, 16 | temperature sensor (air supply temperature adjustment means) |
| 18 | air supply fan |
| 19 | air discharge fan |
| 21 | server rack |
| 22 | server (electronic device) |
| 22a | cooling fan (electronic device fan) |
| 23 | intake air temperature sensor (intake air temperature detection means) |
| 40 | external air conditioning control panel (air supply temperature adjustment means) |
| 41 | IT-side management means (operation information management means) |
| 42 | first storage means |
| 421 | IT-side management software |
| 43 | air-conditioning control means (control means) |
| 44 | second storage means |
| 441 | air-conditioning control software |
| 441a | power-consumption-to-air-amount conversion table |
| 441b | air-amount-to-frequency conversion table |
| 45 | air supply fan inverter |
| 46 | air discharge fan inverter |

**Claims**

1. An air-conditioning control system comprising:

air supply temperature adjustment means for adjusting an air supply temperature to a predetermined value in a case of supplying air to a space to be air-conditioned in which a plurality of electronic devices are installed, by using external air as a cold source;
an air supply fan configured to supply the air subjected to the temperature adjustment by the air supply temperature adjustment means to the space to be air-conditioned;
an air supply fan inverter configured to control a rotation speed of the air supply fan;
an air discharge fan configured to discharge the air from the space to be air-conditioned, the air having absorbed heat from the plurality of electronic devices;
an air discharge fan inverter configured to control a rotation speed of the air discharge fan;
operation information management means for managing operation information on the plurality of electronic devices; and
control means for calculating an air supply amount, when the air is supplied so as to cancel out the heat generated by the plurality of electronic devices, by using the operation information inputted from the operation information management means, and calculating frequencies of the air supply fan inverter and of the air discharge fan inverter on the basis of the air supply amount.

2. The air-conditioning control system according to claim 1, wherein
the operation information includes power consumption by each of the electronic devices, and
the control means calculates the air supply amount on the basis of the power consumption inputted from the operation information management means so as to cancel out the heat generated by the plurality of electronic devices, and calculates the frequencies of the air supply fan inverter and of the air discharge fan inverter on the basis of the air supply amount.

3. The air-conditioning control system according to claim 1, wherein
the operation information includes a frequency of an electronic device fan provided to each of the electronic devices, and
the control means calculates the air supply amount on the basis of the frequencies of the electronic device fans inputted from the operation information management means so as to cancel out the heat generated by the plurality of electronic devices, and calculates the frequencies of the air supply fan inverter and of the air discharge fan inverter on the basis of the air supply amount.

4. The air-conditioning control system according to any one of claims 1 to 3, further comprising:

intake air temperature detection means, provided to each of the electronic devices, for detecting a temperature of the air flowing into the electronic device and outputting the detected temperature to the control means, and
when one of the intake temperature detection means detects a temperature equal to or above a predetermined value, the control means increases the frequencies of the air supply fan inverter and of the air discharge fan inverter.

5. The air-conditioning control system according to any one of claims 1 to 3, further comprising:

intake air temperature detection means for detecting a temperature of the air flowing into each of the electronic devices and outputting the detected temperature to the control means; and
storage means for storing a plurality of power-consumption-to-air-amount conversion tables, each of which shows a correlation between power consumption by each of the electronic devices and an amount of the air to be supplied to the electronic device and corresponds to a preset temperature range, wherein

the control means reads one of the power-consumption-to-air-amount conversion tables corresponding to the temperature detected by the intake air temperature detection means, calculates the air supply amount on the basis of the power consumption by the plurality of electronic devices inputted from the operation information management means so as to cancel out the heat generated by the electronic devices, and calculates the frequencies of the air supply fan inverter and of the air discharge fan inverter on the basis of the air supply amount.

# FIG. 1

EP 2 896 904 A1

# FIG. 2

AIR DISCHARGE     19     AIR DISCHARGE     19     AIR DISCHARGE     19     K

A          B          A          B          A

21          21 21          21 21

h     i          i          i     h          i     i          h

AIR SUPPLY     18     AIR SUPPLY     18     AIR SUPPLY     18

EP 2 896 904 A1

# FIG. 3

SERVER 1 (22)
SERVER 2 (22)
SERVER n (22)

IT-SIDE MANAGEMENT SOFTWARE (42, 421)

IT-SIDE MANAGEMENT MEANS (41)

AIR-CONDITIONING CONTROL MEANS (43)

AIR-CONDITIONING CONTROL SOFTWARE (40, 44)

POWER-CONSUMPTION-TO-AIR-AMOUNT CONVERSION TABLE (441a, 441)

AIR-AMOUNT-TO-FREQUENCY CONVERSION TABLE (441b)

AIR SUPPLY FAN INVERTER (45) — (18)

AIR DISCHARGE FAN INVERTER (46) — (19)

EP 2 896 904 A1

FIG. 4A

AMOUNT OF AIR
REQUIRED

Q1

0
0     P1     POWER CONSUMPTION

FIG. 4B

FREQUENCY OF INVERTER

f

0
0     q     AIR SUPPLY AMOUNT

16

# FIG. 5A

AMOUNT OF AIR
REQUIRED

Q1

0

F1

FREQUENCY OF COOLING
FAN

# FIG. 5B

FREQUENCY OF INVERTER

f

0

q

AIR SUPPLY AMOUNT

# FIG. 6

# FIG. 7

AMOUNT OF AIR
REQUIRED

INTAKE AIR
TEMPERATURE
(HIGH) $\gamma$

$\beta$

$\alpha$

INTAKE AIR
TEMPERATURE
(LOW)

0

0

POWER CONSUMPTION

## INTERNATIONAL SEARCH REPORT

| International application No. |
| --- |
| PCT/JP2013/074389 |

**A. CLASSIFICATION OF SUBJECT MATTER**
*F24F11/04*(2006.01)i, *F24F7/06*(2006.01)i, *H05K7/20*(2006.01)i

According to International Patent Classification (IPC) or to both national classification and IPC

**B. FIELDS SEARCHED**

Minimum documentation searched (classification system followed by classification symbols)
F24F11/04, F24F7/06, H05K7/20

Documentation searched other than minimum documentation to the extent that such documents are included in the fields searched
| Jitsuyo Shinan Koho | 1922–1996 | Jitsuyo Shinan Toroku Koho | 1996–2013 |
| Kokai Jitsuyo Shinan Koho | 1971–2013 | Toroku Jitsuyo Shinan Koho | 1994–2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2011-242008 A (Toshiba Corp.), 01 December 2011 (01.12.2011), paragraphs [0014] to [0022], [0027] to [0033]; fig. 1 to 5 & US 2011/0306287 A1 & WO 2011/142346 A1 & SG 173756 A & CN 102985762 A | 1-5 |
| Y | US 2008/0185446 A1 (Robert M. Tozer), 07 August 2008 (07.08.2008), paragraphs [0011], [0030], [0038] to [0039], [0052] to [0053] & GB 2446454 A & GB 702424 D0 | 1-5 |

☒ Further documents are listed in the continuation of Box C.  ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 08 November, 2013 (08.11.13) | 19 November, 2013 (19.11.13) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

International application No.

PCT/JP2013/074389

**INTERNATIONAL SEARCH REPORT**

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2011-242010 A  (Toshiba Corp.), 01 December 2011 (01.12.2011), paragraphs [0009], [0067], [0073] to [0079]; fig. 1 & US 2011/0306288 A1      & WO 2011/142354 A1 & SG 177234 A                  & CN 102483256 A | 1-5 |
| Y | JP 2011-108022 A  (Takasago Thermal Engineering Co., Ltd.), 02 June 2011 (02.06.2011), paragraphs [0021] to [0025], [0029]; fig. 1 to 4A, 6B (Family: none) | 4-5 |
| A | JP 2010-85011 A  (Hitachi Plant Technologies, Ltd.), 15 April 2010 (15.04.2010), paragraphs [0039] to [0042], [0046] to [0058] & EP 2169328 A2           & SG 160304 A | 1-5 |
| A | JP 2012-154528 A  (Hitachi Plant Technologies, Ltd.), 16 August 2012 (16.08.2012), paragraphs [0032] to [0033], [0040] to [0043] & WO 2012/102155 A1 | 1-5 |

Form PCT/ISA/210 (continuation of second sheet) (July 2009)

**EP 2 896 904 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006220345 A